Europäisches Patentamt

European Patent Office

Office européen des brevets

(11) Numéro de publication: **0 060 772**
**A1**

# (12) DEMANDE DE BREVET EUROPEEN

(21) Numéro de dépôt: **82400417.0**

(51) Int. Cl.³: **H 03 D 3/22**

(22) Date de dépôt: **09.03.82**

(30) Priorité: **17.03.81 FR 8105286**

(43) Date de publication de la demande: **22.09.82**
**Bulletin 82/38**

(84) Etats contractants désignés: **BE DE GB NL**

(71) Demandeur: **THOMSON-CSF, 173, Boulevard Haussmann, F-75360 Paris Cedex 08 (FR)**

(72) Inventeur: **Revellin, Gérard, THOMSON-CSF SCPI 173, bld Haussmann, F-75360 Paris Cedex 08 (FR)**

(74) Mandataire: **Turlèque, Clotilde et al, THOMSON-CSF SCPI 173, Bld Haussmann, F-75360 Paris Cedex 08 (FR)**

(54) **Démodulateur d'un signal modulé en fréquence.**

(57) Le démodulateur selon l'invention comporte une ligne à retard (8) recevant le signal modulé en fréquence $V_e$ et retardant ce signal $V_e$ d'une durée déterminée, et un discriminateur à coïncidence de phase (6) délivrant le signal modulant en fonction de l'écart de phase entre le signal $V_e$ et le signal retardé délivré par la ligne à retard (8).
Application aux systèmes de télévision.

EP 0 060 772 A1

# DEMODULATEUR D'UN SIGNAL MODULE EN FREQUENCE

La présente invention concerne les démodulateurs mettant en oeuvre le principe de détection de phase pour restituer les informations d'un signal modulé en fréquence.

Des démodulateurs à ligne à retard sont connus, ils sont décrits notamment dans les demandes de brevet FR-A- 2 324 161 et FR-A- 2 171 440. Le procédé, qu'ils mettent en oeuvre, consiste à appliquer respectivement aux deux entrées d'un multiplieur ou d'un modulateur en anneaux, d'une part le signal modulé en fréquence, et d'autre part ce même signal retardé d'une durée fixe par une ligne à retard. La linéarité de la réponse est mauvaise si l'excursion de fréquence est importante, car la valeur du signal de sortie est une fonction d'un sinus ou d'un cosinus de l'angle de déphasage entre le signal incident et le signal retardé.

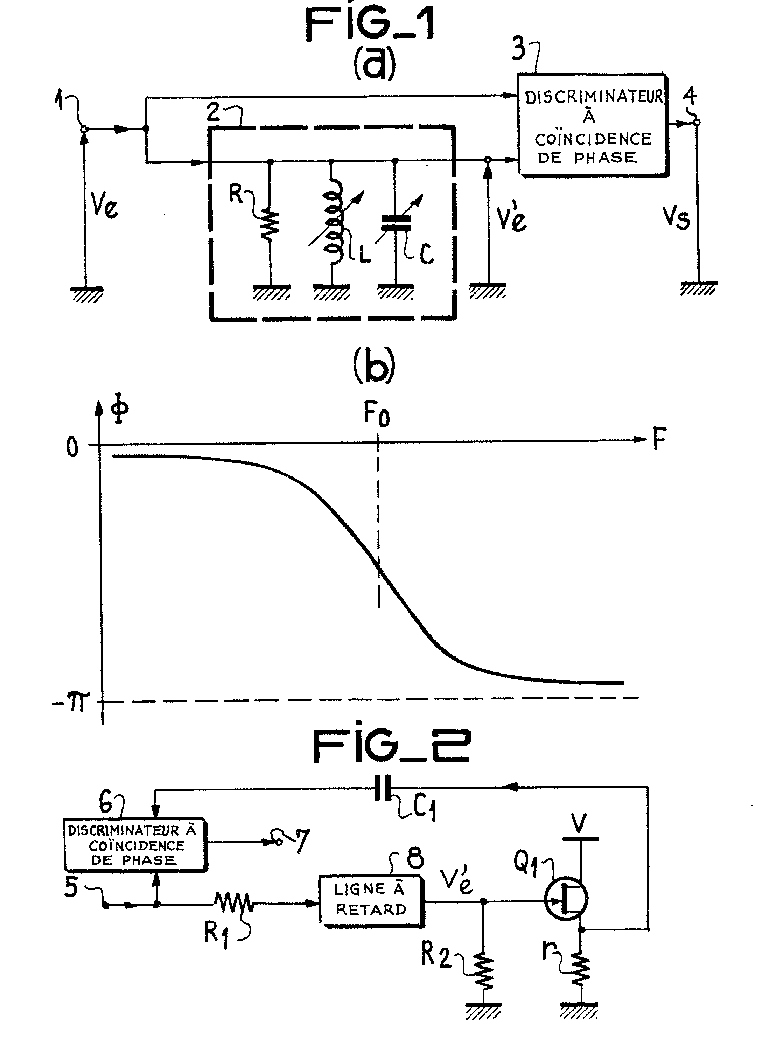

Des démodulateurs utilisant des discriminateurs à coïncidence de phase sont connus. Il sera décrit plus loin à l'aide des figures 1a et 1b un exemple de réalisation de l'un de ces démodulateurs.

Le principe de détection de phase mis en oeuvre par les démodulateurs concernés par l'invention consiste à transformer la variation instantanée de fréquence du signal modulé en une variation proportionnelle de phase, à détecter cette variation de phase, et à en déduire le signal modulant. Ce principe est mis en oeuvre à l'aide d'un déphaseur qui déphase le signal modulé en fréquence $V_e$ d'une valeur proportionnelle à sa fréquence instantanée, et d'un discriminateur à coïncidence de phase qui fournit un signal $V_S$ dont l'amplitude est proportionnelle au déphasage entre le signal $V_e$ et le signal $V'_e$ fourni par le déphaseur, ce signal $V_S$ correspondant au signal modulant désiré.

Il existe de nombreux discriminateurs à coïncidence de phase dans le commerce, par exemple le circuit ULN-2111 commercialisé par SPRAGUE. Pour que l'amplitude de la tension $V_S$ varie linéairement en fonction de la fréquence instantanée du signal $V_e$, il faut que la transformation fréquence-phase engendrée par le déphaseur le soit aussi. Dans ce but, les constructeurs des discriminateurs à coïncidence de phase préconisent un déphaseur constitué d'un circuit accordé RLC comportant une résistance R, une self variable L et une capacité variable C montées en parallèle. Ce circuit accordé correspond à un résonateur parallèle.

Mais la plage de fréquence sur laquelle la courbe déphasage-fréquence d'un tel circuit accordé est linéaire n'est pas très large. Elle est en particulier insuffisante pour la démodulation d'un signal de chrominance SECAM.

Pour augmenter la plage de fréquence, il peut être utilisé deux circuits accordés couplés par capacité, mais le réglage devient alors très délicat.

La présente invention a pour objet de pallier ces inconvénients à l'aide de moyens simples.

Selon l'invention, un démodulateur d'un signal $V_e$ modulé en fréquence par un signal modulant $V_S$, est caractérisé en ce qu'il comporte une ligne à retard ayant une entrée recevant un signal $V_e$ et une sortie fournissant un signal $V'_e$ constitué du signal $V_e$ retardé d'une durée déterminée, et un discriminateur à coïncidence de phase ayant une première entrée recevant le signal $V_e$, une deuxième entrée couplée à la sortie de la ligne à retard, et une sortie fournissant le signal $V_S$.

L'invention sera mieux comprise et d'autres caractéristiques apparaîtront à l'aide de la description ci-après et des dessins s'y rapportant sur lesquels :

- la figure 1a est un schéma synoptique d'un démodulateur connu utilisant un discriminateur à coïncidence de phase ;

- la figure 1b est une représentation phase-fréquence permettant de mieux comprendre le fonctionnement du démodulateur connu représenté sur la figure 1a ;

- la figure 2 est un exemple de réalisation d'un démodulateur selon l'invention.

Le démodulateur décrit sur la figure 1a est connu. Ce démodulateur comporte un circuit accordé 2 ayant une entrée reliée à une borne d'entrée 1. La borne d'entrée 1 est destinée à recevoir le signal de chrominance $V_e$ d'un signal vidéofréquence SECAM. Ce signal $V_e$ est modulé en fréquence autour d'une fréquence centrale $F_o$ égale à 4,3 MHz, et présente un spectre de fréquence s'étendant de 3,9 MHz à 4,7 MHz.

Le circuit accordé 2 déphase le signal $V_e$ d'une valeur $\phi$ proportionnelle à la fréquence instantanée du signal $V_e$. Pour cela le circuit accordé 2 est constitué d'une résistance R, d'une self L variable, et d'une capacité C variable montées en parallèle entre l'entrée du circuit accordé 2 et la masse. Ce circuit accordé 2 correspond à un résonateur parallèle dont le signal de sortie $V'_e$ correspond au signal présent entre les bornes des éléments R, L, et C montés en parallèle. Les valeurs de la self L et de la résistance C sont réglées de façon que le circuit 2 soit accordé sur la fréquence centrale $F_o$ du signal $V_e$.

La borne d'entrée 1 est en outre reliée à une première entrée d'un discriminateur à coïncidence de phase 3 dont une deuxième entrée est connectée à la sortie du circuit accordé 2. La sortie de ce discriminateur à coïncidence de phase 6 est reliée à une borne de sortie 4 et délivre un signal dont l'amplitude est proportionnelle au déphasage entre le signal $V_e$ et le signal $V'_e$. Ce signal correspond au signal modulant $V_S$ recherché.

En fait, le signal $V_e$ est fourni par un amplificateur-limiteur (non représenté) à travers une capacité de couplage $C_c$ (non représentée). Il en résulte que le déphasage $\phi$ engendré par le circuit 2 est donné par la formule suivante :

$$① \, \phi = \pi - \text{arc tg} \, (R_g \, C_c \, \omega) - \text{arc tg} \, \frac{L\omega}{R - RLC\omega^2}$$

$\omega$ étant la pulsation instantanée du signal $V_e$.

$R_g$ étant la résistance de sortie de l'amplificateur-limiteur.

Les valeurs de $R_g$ et de $C_c$ sont très faibles : quelques ohms et quelques picofarads. Le terme arc tg $(R_g \, C_c \, \omega)$ fait donc apparaître une fréquence de coupure très élevée, de l'ordre de 1 GHz. Par rapport à la bande de fréquence 3,9 MHz – 4,7 MHz du signal $V_e$, ce terme peut être négligé.

Le déphasage $\phi$ est donc donné par la formule suivante :

$$\phi = \pi - \text{arc tg} \, \frac{L\omega}{R - RLC\omega^2}$$

Sur la figure 1b, il a été représenté $\phi$ en fonction de la pulsation instantanée $\omega$ du signal $V_e$.

La pente de la courbe autour de la pulsation centrale $\omega_o$ ($\omega_o = 2\pi F_o$) est variable en fonction de l'amortissement apporté par la résistance R, ce qui permet d'élargir la plage de fréquence pour laquelle la courbe est linéaire autour de $\omega_o$. Mais pratiquement, ce n'est pas suffisant pour permettre la démodulation d'un signal de chrominance SECAM. Les meilleurs résultats donnent une zone de linéarité s'étendant sur 500 kHz autour de 4,3 MHz, alors qu'il faudrait 1 MHz.

Pour augmenter la largeur de bande, il peut être utilisé deux résonateurs parallèles couplés par capacité. Les résultats sont sensiblement meilleurs, mais le réglage est très délicat et l'écart de linéarité aux extrémités de la bande 3,9 MHz - 4,7 MHz atteint 3%, ce qui est élevé.

Au lieu d'utiliser le principe de la résonance parallèle, l'invention consiste à employer une ligne à retard, de retard déterminé.

Le schéma d'un exemple de réalisation du démodulateur est alors celui représenté sur la figure 2.

Sur cette figure, une borne d'entrée 5 destinée à recevoir un signal de chrominance $V_e$ d'un signal vidéofréquence SECAM est reliée à une première entrée d'un discriminateur à coïncidence de phase 6. Le signal $V_e$ est fourni par un amplificateur-limiteur (non représenté) à travers une capacité (non représentée). Le discriminateur à coïncidence de phase 6 est le circuit ULN 2111 commercialisé par SPRAGUE. Une deuxième entrée du discriminateur 6 reçoit le signal $V_e$ retardé par une ligne à retard 8.

Pour cela, la borne d'entrée 1 est reliée à l'entrée de la ligne à retard 8 à travers une résistance $R_1$ et la sortie de la ligne à retard 8 est connectée à la masse à travers une résistance $R_2$. Les résistances $R_1$ et $R_2$ ont une valeur identique qui correspond à celle de l'impédance caractéristique de la ligne à retard 8. La sortie de la ligne à retard 8 délivre un signal $V'_e$ correspondant au signal $V_e$ retardé d'un retard déterminé . Ce signal est transmis, à travers un transistor à effet de champ $Q_1$ suivi d'une capacité $C_1$, à la deuxième entrée du discriminateur 6.

Le transistor $Q_1$ est nécessaire pour isoler la ligne à retard 8 de l'impédance d'entrée capacitive du discriminateur 6. Son montage est le suivant : sa porte est reliée à la sortie de la ligne à retard 8, son drain est connecté à une source de tension V, et sa source est reliée à la masse à travers une résistance de polarisation r et à la deuxième entrée du discriminateur 6 à travers la capacité $C_1$.

La capacité $C_1$ sert à bloquer la composante continue du signal $V'_e$.

La sortie du discriminateur 6 est connectée à une borne de sortie 7 et délivre le signal modulant $V_S$ dont l'amplitude est proportionnelle au déphasage entre le signal $V_e$ et le signal retardé $V'_e$.

Le déphasage $\theta$ entre le signal $V_e$ présent sur la première entrée du discriminateur 6 et le signal $V'_e$ présent sur la deuxième entrée du discriminateur 6 est donné par la formule suivante :

$$\theta = \omega\tau$$

Il a été pris expérimentalement une ligne à retard électromagnétique, de retard 68 ns. Il a été trouvé un écart maximum de linéarité de 0,7 % aux extrémités de la bande de fréquence 3,9 MHz - 4,7 MHz , ce qui par rapport à l'écart maximum obtenu avec les démodulateurs connus est nettement meilleur.

La présente invention n'est pas limitée au mode de réalisation décrit et représenté. En particulier, il est à la portée de l'homme de l'art de choisir un autre type de ligne à retard et d'insérer les éléments nécessaires au fonctionnement de cette ligne à retard.

Dans la description, il a été considéré un signal de chrominance d'un signal vidéofréquence SECAM, mais l'invention est bien sûr applicable à partir d'un signal quelconque modulé en fréquence.

## REVENDICATIONS

1. Démodulateur d'un signal $V_e$ modulé en fréquence par un signal modulant $V_S$, caractérisé en ce qu'il comporte une ligne à retard (8) ayant une entrée recevant le signal $V_e$ et une sortie fournissant un signal $V'_e$ constitué du signal $V_e$ retardé d'une durée déterminée, et un discriminateur à coïncidence de phase (6) ayant une première entrée recevant le signal $V_e$, une deuxième entrée couplée à la sortie de la ligne à retard (8), et une sortie fournissant le signal $V_S$.

2. Démodulateur selon la revendication 1, caractérisé en ce qu'il comporte : une première résistance ($R_2$) dont la valeur est celle de l'impédance caractéristique de la ligne à retard (8) et dont la première et la deuxième extrémité sont respectivement couplées à la masse et à la sortie de la ligne à retard (8) ; un transistor à effet de champ ($Q_1$) dont la porte est couplée à la sortie de la ligne à retard (8) ; une source de tension (V) couplée au drain du transistor ($Q_1$) ; une deuxième résistance (r) dont la première et la deuxième extrémité sont respectivement couplées à la masse et à la source du transistor ($Q_1$) ; et une capacité ($C_1$) couplant la source du transistor ($Q_1$) à la deuxième entrée du discriminateur à coïncidence de phase (6), et en ce que l'entrée de la ligne à retard (8) reçoit le signal $V_e$ à travers une troisième résistance ($R_1$) dont la valeur est celle de l'impédance caractéristique de la ligne à retard (8).

0060772

# FIG_1

## (a)

DISCRIMINATEUR À COÏNCIDENCE DE PHASE

$V_e$   $V'_e$   $V_S$

R   L   C

## (b)

$\phi$   $F_0$   $F$

0

$-\pi$

# FIG_2

DISCRIMINATEUR À COÏNCIDENCE DE PHASE

$C_1$

LIGNE À RETARD

$V'_e$   $Q_1$   V

$R_1$   $R_2$   r

# 0060772

Office européen
des brevets

**RAPPORT DE RECHERCHE EUROPEENNE**

Numéro de la demande

EP 82 40 0417

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | <u>FR - A - 2 324 161</u> (SONY)<br><br>* figures 1,3; page 1, lignes 1-11; page 2, ligne 9 - page 3, ligne 16; page 6, ligne 22 - page 7, ligne 23 * | 1 | H 03 D 3/22 |
| X | <u>FR - A - 2 171 440</u> (TED BILDPLATTEN A.G., AEG TELEFUNKEN TELDEC)<br><br>* figures 2,4; page 1, lignes 1-18; page 3, lignes 27-34; page 6, lignes 2-14 * | 1 | |
| X | L'ONDE ELECTRIQUE, volume 58, no. 8,9, août-septembre 1978 PARIS (FR) M.D. POMMIER et al. "Application d'un discriminateur à ligne à retard à la détection d'un signal modulé en fréquence par un signal de télévision", pages 551-557<br><br>* figure 1; paragraphe 1; page 551, paragraphe 2.1, pages 551-552 * | 1 | **DOMAINES TECHNIQUES RECHERCHES (Int. Cl. 3)**<br><br>H 03 D<br>H 04 N<br>H 03 H |
| A | <u>FR - A - 2 026 617</u> (I.B.M.)<br><br>* figure 4; page 1, lines 1-15; page 9, ligne 32 - page 10, ligne 23 * | 2 | |

Le présent rapport de recherche a été établi pour toutes les revendications

| Lieu de la recherche | Date d'achèvement de la recherche | Examinateur |
|---|---|---|
| La Haye | 14-06-1982 | RATAJSKI |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82